(19) Europäisches Patentamt
European Patent Office
Office européen des brevets

(11) **EP 1 797 439 B1**

(12) **EUROPÄISCHE PATENTSCHRIFT**

(45) Veröffentlichungstag und Bekanntmachung des Hinweises auf die Patenterteilung:
**27.02.2013 Patentblatt 2013/09**

(21) Anmeldenummer: **05784457.3**

(22) Anmeldetag: **27.09.2005**

(51) Int Cl.:
*H02M 1/04* *(2006.01)*    *H02M 7/505* *(2006.01)*
*H02M 7/5387* *(2007.01)*    *G01R 19/175* *(2006.01)*

(86) Internationale Anmeldenummer:
**PCT/CH2005/000556**

(87) Internationale Veröffentlichungsnummer:
**WO 2006/037243 (13.04.2006 Gazette 2006/15)**

(54) **VERFAHREN ZUR BESTIMMUNG DES STROMNULLDURCHGANGS IN EINEM UMRICHTER**

METHOD FOR THE DETERMINATION OF CURRENT ZERO CROSSING IN AN INVERTER

PROCÉDÉ POUR LA DÉTERMINATION DU PASSAGE DE COURANT PAR ZÉRO

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **08.10.2004 EP 04405635**

(43) Veröffentlichungstag der Anmeldung:
**20.06.2007 Patentblatt 2007/25**

(73) Patentinhaber: **ABB RESEARCH LTD.**
**8050 Zürich (CH)**

(72) Erfinder:
  • **AKDAG, Alper**
    **CH-5406 Baden-Rütihof (CH)**
  • **STEFANUTTI, Philippe**
    **F-74330 Choisy (FR)**
  • **MEYSENC, Luc**
    **F-38120 Le Fontanil (FR)**
  • **HUGO, Nicolas**
    **CH-1201 Genève (CH)**

(74) Vertreter: **ABB Patent Attorneys**
**C/o ABB Schweiz AG**
**Intellectual Property CH-IP**
**Brown Boveri Strasse 6**
**5400 Baden (CH)**

(56) Entgegenhaltungen:
**US-A1- 2002 089 321    US-B1- 6 535 402**

• **OLIVEIRA A C ET AL: "Dead-time compensation in the zero-crossing current region" PESC'03. 2003 IEEE 34TH. ANNUAL POWER ELECTRONICS SPECIALISTS CONFERENCE. CONFERENCE PROCEEDINGS. ACAPULCO, MEXICO, JUNE 15 - 19, 2003, ANNUAL POWER ELECTRONICS SPECIALISTS CONFERENCE, NEW YORK, NY : IEEE, US, Bd. VOL. 4 OF 4. CONF. 34, 15. Juni 2003 (2003-06-15), Seiten 1937-1942, XP010648587 ISBN: 0-7803-7754-0**
• **PATENT ABSTRACTS OF JAPAN Bd. 007, Nr. 099 (E-172), 27. April 1983 (1983-04-27) -& JP 58 019167 A (TOKYO SHIBAURA DENKI KK), 4. Februar 1983 (1983-02-04)**
• **PATENT ABSTRACTS OF JAPAN Bd. 2000, Nr. 03, 30. März 2000 (2000-03-30) -& JP 11 337629 A (MEIDENSHA CORP), 10. Dezember 1999 (1999-12-10)**
• **VALIVIITA S ET AL: "Adaptive signal processing system for accurate zerocrossing detection of cycloconverter phase currents", POWER CONVERSION CONFERENCE - NAGAOKA 1997., PROCEEDINGS OF THE NAGAOKA, JAPAN 3-6 AUG. 1997, NEW YORK, NY, USA,IEEE, US, vol. 1, 3 August 1997 (1997-08-03), pages 467-472, XP010257351, DOI: 10.1109/PCCON.1997.645656 ISBN: 978-0-7803-3823-4**

**Beschreibung**

*Technisches Gebiet*

Die Erfindung bezieht sich auf das Gebiet der Leistungselektronik. Sie betrifft ein Verfahren zur Bestimmung des Zeitpunkts des Stromnulldurchgangs in einem Umrichter mit mindestens zwei Stromrichterzweigen, wobei der Strom abwechselnd über mindestens einen ersten und über mindestens einen zweiten Stromrichterzweig fliesst, eine Vorrichtung zur Durchführung dieses Verfahrens und einen Umrichter.

*Stand der Technik*

Stromgeführte Umrichter dienen zur Umwandlung von einem Eingangsstrom in einen ein- oder mehr-phasigen Wechselstrom. Die Umrichter enthalten zwei Stromrichterzweige, über die ein Strom I(t) fliessen kann. Jeder der Stromrichterzweige kann durch ein Stromventil in einen Leitzustand oder in einen Sperrzustand geschaltet werden. Ein erstes Stromventil im ersten Stromrichterzweig wird während einer Halbwelle des Stroms, bei welcher der Strom entweder durchgehend positiv oder negativ ist, in Leitzustand geschaltet. Wenn der Strom sein Vorzeichen wechselt, wird das erste Stromventil in Sperrzustand geschaltet und ein zweites Ventil im zweiten Stromrichterzweig, welches während der Zeitdauer, in dem das erste Stromventil in Leitzustand war, in Sperrzustand war, nun in Leitzustand geschaltet. Erfolgt der Übergang von einem Stromrichterzweig in den anderen jedoch nicht genau zu dem Zeitpunkt, an dem der Strom sein Vorzeichen wechselt, kommt es zu einem Überlappungsbereich, in dem beide Stromrichterzweige Strom führen oder zu einem Bereich, in dem in keinem der Stromrichterzweige Strom fliesst. Dieser Überlappungsbereich bzw. der Bereich, in dem in keinem der Stromrichterzweige Strom fliesst, führt jedoch zu grossen Energieverlusten und Einschwingvorgängen.

Zur Bestimmung des Zeitpunktes, an dem die Stromventile geschaltet werden sollen, sind komplexe Verfahren entwickelt worden, welche eine Messung des Stroms beinhalten. Ein solches Verfahren wird in einem Dokument von S. Väliviita, Ovaska S.J., Kyyrä J. ("adaptive signal processing system for accurate zerocrossing detection of cycloconverter phase currents"; IEEJ 1997 - PCC Nagoka, p. 467-472) beschrieben. In dem Verfahren wird ein Niederfrequenz-Vorfilter benutzt, um unerwünschte niederfrequente Frequenzanteile aus dem Stromsignal zu filtern und durch ein mehrstufiges adaptives digitales Filter wird ein sinusförmiger Verlauf des Stromsignals rekonstruiert, aus dem anschliessend der Zeitpunkt des Stromnulldurchgangs vorhergesagt werden kann.

Dieses Verfahren ist jedoch aufwendig und kostenspielig. Fehler in den Strommessungen und des Strom-Offsets setzen die Zuverlässigkeit und Genauigkeit der Bestimmung des Zeitpunkts des Stromnulldurchgangs herab.

US 6,535,402 B1 beschreibt ein Verfahren zur Bestimmung des Stromnulldurchgangs für eine Totzeitkompensation in einem Umrichter, wobei zu dem Strom, von dem der Stromnulldurchgang zu bestimmen ist, ein konstanter Zusatzstrom addiert wird. Von diesem Gesamtstrom wird der Nulldurchgang bestimmt. Durch die Addition des Zusatzstroms entsteht eine Unsymmetrie der Zeitdauern der positiven und negativen Halbwelle. Die Differenz der Zeitdauern der beiden Halbwellen wird benutzt, um von dem gemessenen Stromnulldurchgang auf den vermuteten wahren Zeitpunkt zu korrigieren.

*Darstellung der Erfindung*

Aufgabe der Erfindung ist, ein Verfahren und eine Vorrichtung der eingangs genannten Art zu schaffen, die eine genaue und einfachere Vorhersage des Zeitpunkts des Stromnulldurchgangs in einem Umrichter ermöglichen.

Diese Aufgabe wird erfindungsgemäss durch ein Verfahren zur Stromnulldurchgangsbestimmung in einem Umrichter mit den Merkmalen des Patentanspruchs 1, eine Vorrichtung zur Bestimmung des Zeitpunkts des Stromnulldurchgangs mit den Merkmalen des Patentanspruchs 8 und einen Umrichter mit den Merkmalen des Patentanspruchs 9 gelöst.

Bei dem erfindungsgemässen Verfahren wird der Strom im Umrichter mittels einer Vorrichtung zur Bestimmung des Zeitpunkts des Stromnulldurchgangs gemessen, der gemessene Stromwert in der Vorrichtung mit einem Strom-Schwellwert verglichen und anhand des Zeitpunkts, an dem der Stromwert den Wert des Strom-Schwellwerts vor dem Stromnulldurchgang erreicht, eine voraussichtlichen Zeitdauer $\Delta t$ von dem Erreichen des Strom-Schwellwerts bis zum Erreichen des Stromnulldurchgangs mittels der Vorrichtung ermittelt. Da nur eine Messgrösse zu bestimmen ist und nur einfache Berechnungen notwendig sind, ist dieses Verfahren einfach durchzuführen.

Bei einem sinusförmigen oder annähernd sinusförmigen Verlauf des Stroms lässt sich der Strom in zwei Halbwellen aufteilen, von denen jede Halbwelle die Zeitdauer umfasst, in denen der Strom entweder durchgehend grösser oder durchgehend kleiner als Null ist. Aus den in einer positiven Halbwelle gemessenen Strömen oder den in einer negativen Halbwelle gemessenen Strömen wird eine maximale Amplitude des Stroms der Halbwelle $I_{max}$ bestimmt und die maximale Amplitude des Stroms zur Bestimmung des Zeitpunkts des Stromnulldurchgangs verwendet. Durch die Ermittlung der maximalen Amplitude des Stroms einer Halbwelle wird die Genauigkeit des Verfahrens erhöht.

Die voraussichtliche Zeitdauer $\Delta t$ von dem Erreichen des Strom-Schwellwerts $I_{set}$ bis zum Erreichen des Stromnulldurchgangs kann bei Erreichen des Strom-Schwellwerts vor dem Stromnulldurchgang bestimmt werden aus einem Betrag des Strom-Schwellwerts $|I_{set}|$, der maximalen Amplitude des Stroms $I_{max}$ und einer Frequenz w des Stroms mittels der Gleichung:

$$\Delta t = \frac{1}{\omega} * \frac{|I_{set}|}{I_{max}}$$ , wobei als Strom-Schwellwert $I_{set}$ in

der negativen Halbwelle ein negativer Strom-Schwellwert $I_{set,n}$ und in der positiven Halbwelle ein positiver Strom-Schwellwert $I_{set}$, p eingesetzt wird. Vorteil dieser Ausführungsform ist, dass nur wenige, einfach zu bestimmende Messwerte in die Bestimmung des Stromnulldurchgangs eingehen, und die Bestimmung des Zeitpunkts des Stromnulldurchgangs mittels einer einfachen Gleichung und daher schnell erfolgt.

Weitere vorteilhafte Varianten und Ausführungsformen gehen aus den abhängigen Patentansprüchen hervor.

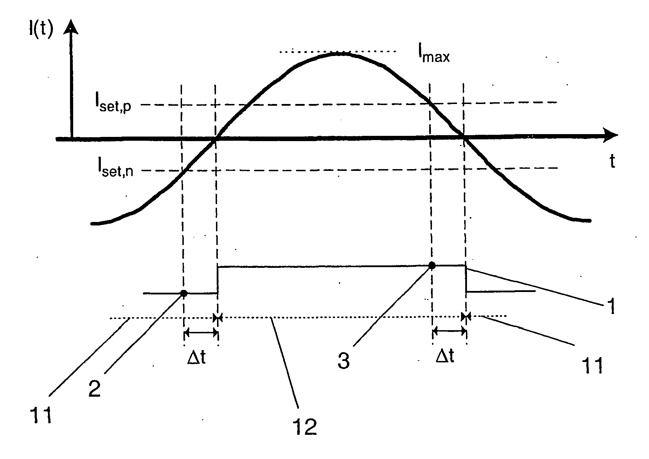

### Kurze Beschreibung der Zeichnung

Im folgenden wird das erfindungsgemässe Verfahren und der Erfindungsgegenstand anhand eines bevorzugten Ausführungsbeispiels, welches in der beiliegenden Zeichnung dargestellt ist, näher erläutert. Die Figur zeigt einen Verlauf des Stroms über die Zeit in einem Umrichter und Schaltverhalten eines ersten Stromventils in einem ersten Stromrichterzweig.

### Wege zur Ausführung der Erfindung

Im folgenden Beispiel wird ein Umrichter mit zwei Stromrichterzweigen beschrieben, die Erfindung ist aber auch anwendbar auf ein- oder mehrphasige Umrichter mit mindestens zwei Stromrichterzweigen.

Die Figur zeigt den Stromverlauf über die Zeit und das Schaltverhalten eines ersten Stromventils in einem ersten Stromrichterzweig. Der Strom im Umrichter wird mittels einer Vorrichtung zur Bestimmung des Zeitpunkts des Stromnulldurchgangs des Umrichters gemessen. Anhand der Kurve 1 ist gezeigt, dass von der negativen Halbwelle aus beginnend von den gemessenen Stromwerten des Umrichters die maximale Amplitude des Stroms $I_{max}$ der negativen Halbwelle bestimmt wird (der Übersichtlichkeit wegen nicht in der Figur dargestellt). Die Ermittlung erfolgt mit einem gängigen Berechnungsverfahren. Bei Erreichen eines negativen Strom-Schwellwerts $I_{set,n}$ nach Durchlaufen der maximalen Amplitude des Stroms und vor dem Stromnulldurchgang 2 wird eine voraussichtliche Zeitdauer $\Delta t$ von dem Erreichen des Strom-Schwellwerts bis zum Erreichen des Stromnulldurchgangs ermittelt. In der positiven Halbwelle wird die maximale Amplitude des Stroms $I_{max}$ bestimmt und bei Erreichen eines positiven Strom-Schwellwerts $I_{set}$, p nach Durchlaufen der maximalen Amplitude des Stroms und vor dem Stromnulldurchgang 3 die voraussichtliche Zeitdauer $\Delta t$ von dem Erreichen des Strom-Schwellwerts bis zum Erreichen des Stromnulldurchgangs ermittelt.

Der momentane Strom I(t) ergibt sich aus der maximalen Amplitude des Stroms $I_{max}$, der Frequenz $\omega$ und der Zeit t nach folgender Gleichung:

$$I(t) = I_{max} \sin(\omega t)$$

Bei kleinen Werten für $(\omega t)$ kann man $|\sin(\omega t)| \approx \omega t$ setzen. Dadurch vereinfacht sich die Gleichung für den Momentanstrom und man kann für einen Betrag des Stromwerts $|I(t)|$ die voraussichtliche Zeitdauer $\Delta t$ von dem Erreichen des Strom-Schwellwerts bis zum Erreichen des Stromnulldurchgangs bestimmen:

$$\Delta t = \frac{1}{\omega} * \frac{|I(t)|}{I_{max}}$$

Bei Erreichen eines vorgegebenen Strom-Schwellwerts $I_{set}$ vor dem Stromnulldurchgang kann die voraussichtliche Zeitdauer $\Delta t$ von dem Erreichen des Strom-Schwellwerts bis zum Erreichen des Stromnulldurchgangs mit der oben angegebenen Gleichung und einem Betrag des Strom-Schwellwerts $|I_{set}|$ wie folgt ermittelt werden.

$$\Delta t = \frac{1}{\omega} * \frac{|I_{set}|}{I_{max}},$$

wobei als Strom-Schwellwert $I_{set}$ in der negativen Halbwelle $I_{set,n}$ und in der positiven Halbwelle $I_{set}$, p eingesetzt wird.

Kurve 1 zeigt, dass aufgrund der Ermittlung der voraussichtlichen Zeitdauer $\Delta t$ von dem Erreichen des Strom-Schwellwerts bis zum Erreichen des Stromnulldurchgangs die Umschaltung zwischen zwei Stromrichterzweigen um die Zeitdauer $\Delta t$ nach Erreichen des vorgegebenen Strom-Schwellwerts verzögert ausgelöst wird. In der Figur ist der Übersichtlichkeit wegen nur der Zustand des ersten Stromrichterzweiges gezeigt. In der negativen Halbwelle ist der erste Stromrichterzweig in Leitzustand 11 und der zweite Stromrichterzweig in Sperrzustand. Nach Ablauf der Zeitdauer $\Delta t$ nach Erreichen des vorgegebenen negativen Strom-Schwellwerts $I_{set,n}$ wird der erste Stromrichterzweig in Sperrzustand geschaltet 12 und der zweite Stromrichterzweig in Leitzustand. In der positiven Halbwelle wird nach Ablauf der Zeitdauer $\Delta t$ nach Erreichen des vorgegebenen positiven Strom-Schwellwerts $I_{set}$, p der erste Stromrichterzweig wieder in Leitzustand geschaltet 11 und der zweite Stromrichterzweig in Sperrzustand.

Der Strom-Schwellwert $I_{set, n}$ für die negative Halbwelle und $I_{set, p}$ für die positive Halbwelle kann betriebsabhängig vorgegeben werden. Falls der Strom beeinflusst wird von Rauschen, kann der Wert vorteilhafterweise so gross gewählt werden, dass der Stromwert deutlich vom Rauschen unterschieden werden kann. Andererseits sollte der Stromwert so niedrig sein, dass der Fehler, den man durch die Näherung von $|\sin(\omega t)| \approx \omega t$ macht, klein bleibt.

Die maximale Amplitude des Stroms kann innerhalb jeder Halbwelle neu bestimmt werden, es ist aber auch denkbar, nur für jede zweite oder höchstens jede zweite Halbwelle eine maximale Amplitude des Stroms neu zu bestimmen. Wenn die maximale Amplitude innerhalb einer Halbwelle bestimmt wird und dieser Wert für die Ermittlung der Zeitdauer bis zum direkt darauf folgenden oder übernächsten Stromnulldurchgang benutzt wird, erhält man ein besonders genaues Ergebnis. Wenn die maximale Amplitude des Stroms erst für die Ermittlung der Zeitdauer bis zu einem späteren Stromnulldurchgang verwendet wird oder wenn die maximale Amplitude nicht für jede Halbwelle neu bestimmt wird, kann das Verfahren besonders schnell durchgeführt werden.

Besonders einfach wird das Verfahren auch, wenn der Betrag des negativen Strom-Schwellwerts $|I_{set,n}|$ gleich dem Betrag des positiven Strom-Schwellwerts $|I_{set,p}|$ ist. Dann kann eine Konstante aus dem Produkt aus der Frequenz $\omega$ und des Strom-Schwellwerts ermittelt werden und in jeder Halbwelle braucht nur der Quotient aus der Konstante und der maximalen Amplitude des Stroms einer Halbwelle berechnet zu werden, um die voraussichtliche Zeitdauer $\Delta t$ von dem Erreichen des Strom-Schwellwerts bis zum Erreichen des Stromnulldurchgangs zu bestimmen.

Das erfindungsgemässe Verfahren zur Stromnulldurchgangsbestimmung in einem Umrichter kann mittels einer Vorrichtung, die ein Mittel zur Messung des Stroms und ein Datenverarbeitungssystem zum Vergleich der Strom-Schwellwerte und zur Ermittlung der voraussichtlichen Zeitdauer von dem Erreichen des Strom-Schwellwerts bis zum Erreichen des Stromnulldurchgangs umfasst, durchgeführt werden. Bei dem Verfahren wird der Strom mittels der Vorrichtung gemessen, der gemessene Stromwert in der Datenverarbeitungssystem mit einem Strom-Schwellwert $I_{set}$ verglichen und anhand des Zeitpunkts, an dem der Strom den Wert des Strom-Schwellwerts vor dem Stromnulldurchgang erreicht, eine voraussichtliche Zeitdauer $\Delta t$ von dem Erreichen des Strom-Schwellwerts bis zum Erreichen des Stromnulldurchgangs mittels des Datenverarbeitungssystems ermittelt.

Ein Computerprogramm für die Stromnulldurchgangsbestimmung ist ladbar in das Datenverarbeitungssystem und ausführbar in dem Datenverarbeitungssystem. Wenn das Computerprogramm ausgeführt wird, vergleicht es den gemessenen Stromwert mit einem Strom-Schwellwert $I_{set}$ und ermittelt anhand des Zeitpunkts, an dem der Strom den Wert des Strom-Schwellwerts vor dem Stromnulldurchgang erreicht, eine voraussichtliche Zeitdauer $\Delta t$ von dem Erreichen des Strom-Schwellwerts bis zum Erreichen des Stromnulldurchgangs.

In einer anderen Variante des Verfahrens wird der Stromnulldurchgang in einem Umrichter bestimmt mittels einer Vorrichtung, die ein Mittel zur Messung des Stroms und einen elektrischen Schaltkreis zum Vergleich des Strom-Schwellwerts sowie zur Ermittlung der voraussichtlichen Zeitdauer von dem Erreichen des Strom-Schwellwerts bis zum Erreichen des Stromnulldurchgangs umfasst.

Bei Umrichtern kann vor jedem Stromrichterzweig ein Ventil eingebaut sein, durch das ein Stromrichterzweig in einen Sperrzustand oder Leitzustand geschaltet werden kann. Wenn ein solches Ventil die Umschaltung des jeweiligen Stromrichterzweiges zeitverzögert von dem Zeitpunkt vornimmt, an dem die Umschaltung ausgelöst wird, kann die Zeitverzögerung bis zum Umschalten derart berücksichtigt werden, dass der Strom-Schwellwert so gross gewählt wird, dass die voraussichtliche Zeitdauer $\Delta t$ von dem Erreichen des Strom-Schwellwerts bis zum Erreichen des Stromnulldurchgangs grösser oder gleich der Zeitverzögerung bis zum Umschalten ist. Die Zeitverzögerung kann derart in der Ermittlung der voraussichtlichen Zeitdauer $\Delta t$ von dem Erreichen des Strom-Schwellwerts bis zum Erreichen des Stromnulldurchgangs berücksichtigt werden, dass das jeweilige Ventil zu einem Zeitpunkt vor einem Stromnulldurchgang, welcher der Zeitverzögerung entspricht, geschaltet wird und das Ventil zum Zeitpunkt des Stromnulldurchgangs sperrt oder durchlässt.

Das vorgängig beschriebene Verfahren zum Betreiben eines Umrichters kann in einem Umrichter angewendet werden, in dem ein kontinuierlicher Stromfluss gefordert ist und in dem der Stromfluss nicht durch einen aktiv herbeigeführten Vorgang wie das Schalten eines Ventils unterbrochen werden soll.

Eine weitere Anwendung des Verfahrens findet in einem stromgeführten Umrichter statt. In einem stromgeführten Umrichter verhält sich der Strom, der in den Umrichter gespeist wird, wie eine Stromquelle und am Ausgang des Umrichters wird eine Strommenge unabhängig von der Ausgangsspannung abgegeben (wie eine Stromquelle).

Das Verfahren kann auch in einem Direkt-Umrichter angewendet werden, in dem Wechselstrom einer vorgegebenen Frequenz in Wechselstrom einer anderen Frequenz direkt umgewandelt wird, ohne dass der Wechselstrom zwischenzeitlich in Gleichstrom umgewandelt wird.

**Patentansprüche**

1. Verfahren zur Stromnulldurchgangsbestimmung in einem Umrichter mit mindestens zwei Stromrichterzweigen, wobei der Strom abwechselnd über mindestens einen ersten und über mindestens einen zweiten Stromrichterzweig fliesst und mit einer Vorrichtung zur Bestimmung des Zeitpunkts des Stromnulldurchgangs, **dadurch gekennzeichnet, dass** der Strom mittels der Vorrichtung gemessen wird, aus den gemessenen Stromwerten eine maximale Amplitude des Stroms $I_{max}$ in einer positiven und / oder negativen Halbwelle bestimmt wird, der gemessene Stromwert in der Vorrichtung mit einem Strom-Schwellwert $I_{set}$ verglichen wird und anhand des Zeitpunkts, an dem der Strom den Wert des Strom-Schwellwerts $I_{set}$ vor dem Stromnulldurchgang erreicht, und des Wertes der maximalen Amplitude des Stroms $I_{max}$ einer Halbwelle eine voraussichtliche Zeitdauer $\Delta t$ von dem Erreichen des Strom-Schwellwerts $I_{set}$ bis zum Erreichen des Stromnulldurchgangs mittels der Vorrichtung ermittelt wird.

2. Verfahren nach Anspruch 1, **dadurch gekennzeichnet, dass** der Strom einen sinusförmigen Verlauf aufweist.

3. Verfahren nach Anspruch 1 oder 2, **dadurch gekennzeichnet, dass** die voraussichtliche Zeitdauer $\Delta t$ von dem Erreichen des Strom-Schwellwerts $I_{set}$ bis zum Erreichen des Stromnulldurchgangs innerhalb derselben Halbwelle, von welcher die maximale Amplitude des Stroms $I_{max}$ ermittelt wird, bestimmt wird.

4. Verfahren nach einem der Ansprüche 2 oder 3, **dadurch gekennzeichnet, dass** die voraussichtliche Zeitdauer $\Delta t$ von dem Erreichen des Strom-Schwellwerts $I_{set}$ bis zum Erreichen des Stromnulldurchgangs bestimmt wird aus einem Betrag des Strom-Schwellwerts $|I_{set}|$, der maximalen Amplitude des Stroms $I_{max}$ und einer Frequenz w des Stroms mittels

der Gleichung: $\Delta t = \dfrac{1}{\omega} * \dfrac{|I_{set}|}{I_{max}}$, wobei als

Strom-Schwellwert $I_{set}$ in der negativen Halbwelle ein negativer Strom-Schwellwert $I_{set,n}$ und in der positiven Halbwelle ein positiver Strom-Schwellwert $I_{set,p}$ eingesetzt wird.

5. Verfahren nach Anspruch 4, **dadurch gekennzeichnet, dass** ein Betrag des negativen Strom-Schwellwerts $|I_{set,n}|$ und ein Betrag des positiven Strom-Schwellwerts $|I_{set,p}|$ gleich gross sind.

6. Verfahren nach einem der Ansprüche 1 bis 5, **dadurch gekennzeichnet, dass** nach Ablauf der voraussichtlichen Zeitdauer $\Delta t$ von dem Erreichen des Strom-Schwellwerts bis zum Erreichen des Stromnulldurchgangs in mindestens einem Stromrichterzweig jeweils ein Stromventil geschaltet wird, welches jeweils einen Stromrichterzweig umschaltet zwischen einem Leitzustand und einem Sperrzustand.

7. Verfahren nach Anspruch 6, **dadurch gekennzeichnet, dass** das mindestens eine Stromventil nach einem Schaltvorgang erst nach einer Zeitverzögerung den jeweiligen Stromrichterzweig sperrt oder durchlässt und der Strom-Schwellwert $I_{set}$ so gross ist, dass die voraussichtliche Zeitdauer $\Delta t$ von dem Erreichen des Strom-Schwellwerts bis zum Erreichen des Stromnulldurchgangs grösser oder gleich der Zeitverzögerung bis zum Sperren oder Durchlassen ist und die Zeitverzögerung derart in der Ermittlung der voraussichtlichen Zeitdauer $\Delta t$ von dem Erreichen des Strom-Schwellwerts bis zum Erreichen des Stromnulldurchgangs berücksichtigt wird, dass das jeweilige Ventil zu einem Zeitpunkt vor einem Stromnulldurchgang, welcher der Zeitverzögerung entspricht, geschaltet wird und das Ventil zum Zeitpunkt des Stromnulldurchgangs sperrt oder durchlässt.

8. Vorrichtung zur Bestimmung des Zeitpunkts des Stromnulldurchgangs, **dadurch gekennzeichnet, dass** die Vorrichtung zur Bestimmung des Zeitpunkts des Stromnulldurchgangs Mittel zur Messung des Stroms am Eingang eines Stromrichterzweiges, Mittel zum Vergleichen des gemessenen Stromwerts mit einem Strom-Schwellwert, Mittel zur Bestimmung einer maximale Amplitude des Stroms $I_{max}$ in einer positiven und / oder negativen Halbwelle aus den gemessenen Stromwerten und Mittel zur Ermittlung der voraussichtlichen Zeitdauer $\Delta t$ von dem Erreichen des Strom-Schwellwerts bis zum Erreichen des Stromnulldurchgangs anhand des Zeitpunkts, an dem der Strom den Wert des Strom-Schwellwerts vor dem Stromnulldurchgang erreicht, und des Wertes der maximalen Amplitude des Stroms $I_{max}$ einer Halbwelle umfasst.

9. Umrichter, mindestens zwei Stromrichterzweige enthaltend, wobei der Strom abwechselnd über einen ersten und über einen zweiten Stromrichterzweig fliesst, **dadurch gekennzeichnet, dass** der Umrichter eine Vorrichtung zur Bestimmung des Zeitpunkts des Stromnulldurchgangs nach Anspruch 8 umfasst.

## Claims

1. Method for determining the current zero crossing in a converter having at least two converter branches, the current flowing alternately via at least one first converter branch and via at least one second converter branch, and having an apparatus for determining the time of the current zero crossing, **characterized in that** the current is measured using the apparatus, a maximum amplitude of the current $I_{max}$ in a positive and/or negative half-cycle is determined from the measured current values, the measured current value is compared with a current threshold value $I_{set}$ in the apparatus, and a likely period of time $\Delta t$ between reaching the current threshold value $I_{set}$ and reaching the current zero crossing is determined by means of the apparatus using the time at which the current reaches the value of the current threshold value $I_{set}$ before the current zero crossing and using the value of the maximum amplitude of the current $I_{max}$ in a half-cycle.

2. Method according to Claim 1, **characterized in that** the current has a sinusoidal profile.

3. Method according to Claim 1 or 2, **characterized in that** the likely period of time $\Delta t$ between reaching the current threshold value $I_{set}$ and reaching the current zero crossing is determined within the same half-cycle from which the maximum amplitude of the current $I_{max}$ is determined.

4. Method according to either of Claims 2 and 3, **characterized in that** the likely period of time $\Delta t$ between reaching the current threshold value $I_{set}$ and reaching the current zero crossing is determined from a magnitude of the current threshold value $|I_{set}|$, the maximum amplitude of the current $I_{max}$ and a frequency $\omega$ of the current using the equation:

$$\Delta t = \frac{1}{\omega} * \frac{|I_{set}|}{I_{max}},$$

a negative current threshold value $I_{set,n}$ being used in the negative half-cycle as the current threshold value $I_{set}$ and a positive current threshold value $I_{set,p}$ being used in the positive half-cycle as the current threshold value $I_{set}$.

5. Method according to Claim 4, **characterized in that** a magnitude of the negative current threshold value $|I_{set,n}|$ and a magnitude of the positive current threshold value $|I_{set,p}|$ are the same.

6. Method according to one of Claims 1 to 5, **characterized in that**, after the likely period of time $\Delta t$ between reaching the current threshold value and reaching the current zero crossing has elapsed, a respective current valve is switched in at least one converter branch, which valve changes over a respective converter branch between a conducting state and a blocking state.

7. Method according to Claim 6, **characterized in that** the at least one current valve blocks or opens the respective converter branch after a switching operation only after a time delay, and the current threshold value $I_{set}$ is so large that the likely period of time $\Delta t$ between reaching the current threshold value and reaching the current zero crossing is greater than or equal to the time delay before closing or opening, and the time delay is taken into account in the determination of the likely period of time $\Delta t$ between reaching the current threshold value and reaching the current zero crossing in such a manner that the respective valve is switched at a time before a current zero crossing which corresponds to the time delay, and the valve blocks or opens at the time of the current zero crossing.

8. Apparatus for determining the time of the current zero crossing, **characterized in that** the apparatus for determining the time of the current zero crossing comprises means for measuring the current at the input of a converter branch, means for comparing the measured current value with a current threshold value, means for determining a maximum amplitude of the current $I_{max}$ in a positive and/or negative half-cycle from the measured current values and means for determining the likely period of time $\Delta t$ between reaching the current threshold value and reaching the current zero crossing using the time at which the current reaches the value of the current threshold value before the current zero crossing and using the value of the maximum amplitude of the current $I_{max}$ in a half-cycle.

9. Converter containing at least two converter branches, the current flowing alternately via a first converter branch and via a second converter branch, **characterized in that** the converter comprises an apparatus for determining the time of the current zero crossing according to Claim 8.

**Revendications**

1. Procédé de détermination du passage par zéro du courant dans un convertisseur statique comprenant au moins deux branches de convertisseur, le courant circulant en alternance sur au moins une première et sur au moins une deuxième branche de convertisseur, et comprenant un dispositif pour déterminer l'instant du passage par zéro du courant, **caractérisé en ce que** le courant est mesuré au moyen du dispositif, une amplitude maximale du courant $I_{max}$ dans une demi-onde positive et/ou négative est déterminée à partir des valeurs mesurées du courant, la valeur mesurée du courant est comparée dans le dispositif avec une valeur de seuil du courant $I_{set}$ et une durée prévisionnelle $\Delta t$ entre le moment d'atteindre la valeur de seuil du courant $I_{set}$ et le moment d'atteindre le passage par zéro du courant est déterminée au moyen du dispositif au moyen de l'instant auquel le courant atteint la valeur de la valeur de seuil du courant $I_{set}$ avant le passage par zéro du courant et de la valeur de l'amplitude maximale du courant $I_{max}$ d'une demi-onde.

2. Procédé selon la revendication 1, **caractérisé en ce que** le courant présente un tracé sinusoïdal.

3. Procédé selon la revendication 1 ou 2, **caractérisé en ce que** la durée prévisionnelle $\Delta t$ entre le moment d'atteindre la valeur de seuil du courant $I_{set}$ et le moment d'atteindre le passage par zéro du courant est déterminée au sein de la même demi-onde que celle pour laquelle l'amplitude maximale du courant $I_{max}$ a été déterminée.

4. Procédé selon l'une des revendications 2 ou 3, **caractérisé en ce que** la durée prévisionnelle $\Delta t$ entre le moment d'atteindre la valeur de seuil du courant $I_{set}$ et le moment d'atteindre le passage par zéro du courant est déterminée à partir d'une valeur absolue de la valeur de seuil du courant $|I_{set}|$, de l'amplitude maximale du courant $I_{max}$ et d'une fréquence $\omega$ du courant au moyen de l'équation $\Delta t = \frac{1}{\omega} * \frac{|I_{set}|}{I_{max}}$, la valeur de seuil du courant $I_{set}$ utilisée dans la demi-onde négative étant une valeur de seuil du courant négative $I_{set,n}$ et celle utilisée dans la demi-onde positive étant une valeur de seuil du courant positive $I_{set,p}$.

5. Procédé selon la revendication 4, **caractérisé en ce qu'**une valeur absolue de la valeur de seuil du courant négative $|I_{set,n}|$ et une valeur absolue de la valeur de seuil du courant positive $|I_{set,p}|$ sont identiques.

6. Procédé selon l'une des revendications 1 à 5, **caractérisé en ce qu'**après écoulement de la durée prévisionnelle $\Delta t$ entre le moment d'atteindre la valeur de seuil du courant et le moment d'atteindre le passage par zéro du courant, une vanne de courant est respectivement commutée dans au moins une branche de convertisseur, laquelle permute respectivement une branche de convertisseur entre un état passant et un état bloqué.

7. Procédé selon la revendication 6, **caractérisé en ce que** l'au moins une vanne de courant ne bloque ou ne rend passante la branche de convertisseur correspondante après une opération de commutation qu'après une temporisation et la valeur de seuil du courant $I_{set}$ est élevée au point que la durée prévisionnelle $\Delta t$ entre le moment d'atteindre la valeur de seuil du courant et le moment d'atteindre le passage par zéro du courant est supérieure ou égale à la temporisation jusqu'au blocage ou à l'établissement de l'état passant et la temporisation est prise en compte dans la détermination de la durée prévisionnelle $\Delta t$ entre le moment d'atteindre la valeur de seuil du courant et le moment d'atteindre le passage par zéro du courant de telle sorte que la vanne correspondante est commutée à un instant avant un passage par zéro du courant, lequel correspond à la temporisation, et la vanne bloque ou établit le passage à l'instant du passage par zéro du courant.

8. Dispositif de détermination de l'instant du passage par zéro du courant, **caractérisé en ce que** le dispositif de détermination de l'instant du passage par zéro du courant comprend des moyens pour mesurer le courant à l'entrée d'une branche de convertisseur, des moyens pour comparer la valeur mesurée du courant avec une valeur de seuil du courant, des moyens pour déterminer une amplitude maximale du courant $I_{max}$ dans une demi-onde positive et/ou négative à partir des valeurs mesurées du courant et des moyens pour déterminer une durée prévisionnelle $\Delta t$ entre le moment d'atteindre la valeur de seuil du courant et le moment d'atteindre le passage par zéro du courant, au moyen de l'instant auquel le courant atteint la valeur de la valeur de seuil du courant $I_{set}$ avant le passage par zéro du courant et la valeur de l'amplitude maximale du courant $I_{max}$ d'une demi-onde.

9. Convertisseur statique comprenant au moins deux branches de convertisseur, le courant circulant en alternance sur une première et sur une deuxième branche de convertisseur, **caractérisé en ce que** le convertisseur statique comprend un dispositif pour déterminer l'instant du passage par zéro du courant selon la revendication 8.

I(t)

$I_{max}$

$I_{set,p}$

t

$I_{set,n}$

$\Delta t$

2

11

12

3

$\Delta t$

1

11

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 6535402 B1

### In der Beschreibung aufgeführte Nicht-Patentliteratur

- **S. VÄLIVIITA ; OVASKA S.J. ; KYYRÄ J.** adaptive signal processing system for accurate zerocrossing detection of cycloconverter phase currents. *IEEJ 1997 - PCC Nagoka,* 1997, 467-472